# EUROPEAN PATENT APPLICATION

(11) **EP 4 597 548 A1**
(43) Date of publication of application: **06.08.2025**
(21) Application number: 24875728.8
(22) Date of filing: 29.07.2024
(51) Int. Cl.: H01L 21/324, H01L 21/205

(54) **MATERIAL PROCESSING METHOD FOR IMPROVING CHANNEL MOBILITY OF SILICON CARBIDE METAL OXIDE SEMICONDUCTOR FIELD EFFECT TRANSISTOR**

(30) Priority: 17.11.2023 CN 202311537734
(71) Applicant: China Electronics Technology Group Corporation No.55 Research Institute, Nanjing, Jiangsu 210016 (CN)
(72) Inventor: LI, Yun, Jiangsu 210016 (CN); ZHAO, Zhifei, Jiangsu 210016 (CN); WANG, Yi, Jiangsu 210016 (CN); ZHOU, Ping, Jiangsu 210016 (CN)
(74) Representative: Frick, Robert
(86) International application number: PCT/CN2024/108064
(87) International publication number: WO 2025/102821

(57) **Abstract**

The present application discloses a material processing method for improving a channel mobility of a silicon carbide metal oxide semiconductor field effect transistor. **In** the method, after an n-type and a p-type ion implantation of a SiC wafer, a high-temperature annealing activation in an argon atmosphere is not performed, the silicon carbide wafer directly enters an epitaxial furnace to perform an annealing activation in a hydrogen atmosphere, and in order to avoid a hydrogen etching in the high-temperature annealing activation process from damaging the wafer structure, a high-concentration n-type heavily doped SiC epitaxial layer is firstly epitaxially grown as a hydrogen etching sacrificial layer. By introducing a low-flow silicon source in the hydrogen atmosphere, the hydrogen etching rate is effectively inhibited, and a silicon-rich and nitrogen-rich surface is formed after the etching of the n-type heavily doped SiC epitaxial layer, so that the mobility of the n-channel of the SiC MOSFET device is further improved. The present application is suitable for the existing commercial SiC epitaxial furnace, the process is compatible with the existing conventional epitaxial process, which can be utilized for a mass production of commercial SiC epitaxial wafers.

## Description

### TECHNICAL FIELD

The present application relates to the technical field of semiconductor monocrystalline films, in particular to a material processing method for improving a channel mobility of a silicon carbide metal oxide semiconductor field effect transistor.

### BACKGROUND

As a wide bandgap semiconductor material, silicon carbide (SiC) has the characteristics such as high critical breakdown electric field intensity, high electron saturation velocity, high thermal conductivity, and is an ideal material for preparing high-voltage and high-power electronic devices. At present, the 4H crystal form SiC is widely applied to the development of power electronic devices. The SiC MOSFET is a unipolar device with an insulated-gate structure and has the characteristics of high switching speed and high frequency.

In the SiC MOSFET device process, the gate oxide process is a critical step. At present, the gate oxide process mainly has two main methods, namely (1) directly growing a silicon dioxide layer by adopting the low-pressure chemical vapor deposition (LPCVD) equipment and (2) directly oxidizing a SiC wafer in an oxidation furnace, and forming the silicon dioxide layer by the reaction of oxygen and SiC. Regardless of the type of gate oxide process, the gate oxide process is carried out after the SiC wafer implantation and the high-temperature activation, so the surface quality of the SiC wafer after the implantation and the activation at the high temperature directly affects the subsequent gate oxide interface quality, the conventional process for activating the SiC wafer at the high temperature is carried out in the argon atmosphere, and the activation temperature is higher than 1600 °C, in order to avoid the significant increase in the surface roughness of the wafer caused by the sublimation of silicon atoms on the surface of the SiC material, a layer of carbon film is covered on the surface of the SiC to prevent the sublimation of the silicon atoms before the high-temperature annealing, and after the annealing, the carbon film is removed by oxygen plasma for the ashing treatment and the oxygen heat treatment at 900 °C. The process steps are complex, and after the high-temperature activation treatment, the surface roughness rms of the wafer is generally more than 1 nm, and there is still the room for optimization.

### SUMMARY

The technical problems to be solved are as follows.

The technical problems to be solved in the present application are that the process steps are complex, the surface roughness is increased, the increase of the roughness can cause an increase in the density of states at the gate oxide interface, resulting in a decrease in the channel mobility of the device and the reliability degradation, and a material processing method for improving a channel mobility of a silicon carbide metal oxide semiconductor field effect transistor is provided.

The technical solutions are adopted in the present application.

Provided is a material processing method for improving a channel mobility of a silicon carbide metal oxide semiconductor field effect transistor. In the method, an in-situ pretreatment is performed on a silicon carbide wafer after an ion implantation in a hydrogen atmosphere by adopting chemical vapor deposition equipment, and a high concentration n-type heavily doped SiC epitaxial layer with a concentration of ≥ 5E17 cm⁻³ is grown on a surface of the silicon carbide wafer after the ion implantation as a sacrificial layer, a high-temperature annealing activation treatment is performed on the silicon carbide wafer after the growth of the n-type heavily doped SiC epitaxial layer in the hydrogen atmosphere, after the high temperature annealing activation in hydrogen atmosphere is completed, the n-type heavily doped SiC epitaxial layer is completely etched and removed by hydrogen or only a thin layer with a thickness of less than 10 nm remains, and whether to epitaxially grow an unintentionally doped SiC thin layer is selected according to a difference of whether a process of directly oxidizing the silicon carbide wafer is adopted in a subsequent actually doped gate oxide process or not.

Further, in the material processing method for improving the channel mobility of the silicon carbide metal oxide semiconductor field effect transistor, process conditions are specifically as follows.

In Step 1, the silicon carbide wafer after the n-type implantation and the p-type ion implantation is placed into a reaction chamber.

In Step 2, the reaction chamber is heated to a temperature range of 1450 °C to 1550 °C in the hydrogen atmosphere by adopting the chemical vapor deposition CVD equipment, and the temperature is maintained for a duration of 0.5 minutes to 2 minutes to perform the in-situ pretreatment on the silicon carbide wafer.

In Step 3, the temperature in the reaction chamber is raised to a temperature range of 1550 °C to 1650 °C, a growth source and nitrogen are introduced, and the n-type heavily doped SiC epitaxial layer is grown on the silicon carbide wafer, a doping concentration of the epitaxial layer is ≥5E17 cm⁻³.

In Step 4, after the growth of the n-type heavily doped SiC epitaxial layer, the temperature in the reaction chamber is raised to a temperature range of 1550 °C to 1750 °C; the high-temperature annealing activation treatment is performed on the silicon carbide wafer in the hydrogen atmosphere, a silicon source with the concentration of ≤0.04% is introduced during a process of the high-temperature annealing activation treatment, the n-type heavily doped SiC epitaxial layer is continuously etched by hydrogen, the time is controlled to reserve the n-type heavily doped SiC epitaxial layer with a thickness of 0 nm to 10 nm.

In Step 5, according to the difference of whether the process of directly oxidizing the silicon carbide wafer is adopted in the subsequent actually doped gate oxide process or not, whether to epitaxially grow the unintentionally doped SiC thin layer is selected.

In Step 6, a heater is turned off in the hydrogen atmosphere to naturally cool the reaction chamber to a room temperature.

In Step 7, the reaction chamber is replaced with an argon atmosphere, and the reaction chamber is opened to take out the SiC wafer.

As a preferred technical solution of the present application, in Step 4, the silicon source is silane or trichlorosilane.

As a preferred technical solution of the present application, according to the difference of whether the process of directly oxidizing the silicon carbide wafer is adopted in the subsequent actually doped gate oxide processor not, whether to epitaxially grow the unintentionally doped SiC thin layer with a thickness of 15 nm to 40 nm in Step 5 is selected; when low pressure chemical vapor deposition LPCVD equipment is adopted in the subsequent actual gate oxide process to directly grow the silicon dioxide layer, Step 6 is directly entered with no additional treatment; when a method for forming silicon dioxide by directly oxidizing a wafer is adopted in the subsequent actual gate oxide process, a growth source is introduced into a reaction chamber, and an unintentionally doped SiC thin layer with a thickness of 15 nm to 40 nm, namely an unintentionally doped SiC epitaxial layer, is grown.

As a preferred technical solution of the present application, the growth source in Step 3 consists of a silicon source and a carbon source, the silicon source is silane and/or trichlorosilane, and the carbon source is ethylene and/or propane.

As a preferred technical solution of the present application, the thickness of the n-type heavily doped SiC epitaxial layer grown in Step 3 is not less than a hydrogen etching amount in the high-temperature annealing activation treatment process in the hydrogen atmosphere in Step 4; the hydrogen etching amount is obtainable by multiplying a hydrogen etching rate by the processing time in Step 4; the hydrogen etching rate Er requires an additional experimental calibration: a SiC epitaxial wafer with a known thickness d1 is adopted, a same process condition in Step 4 is adopted to perform a treatment with a duration of t, and a thickness of the SiC epitaxial wafer is measured again to be d2 after the treatment to obtain the hydrogen etching rate Er=(d1-d2)/t.

Principle explanation: the present application provides a material processing method for improving a channel mobility of a SiC MOSFET, after the n-type and the p-type ion implantation of a SiC wafer is completed, the high-temperature annealing activation in the argon atmosphere is not performed, and the SiC wafer directly enters an epitaxial furnace to perform the annealing activation in the hydrogen atmosphere, so that serious degradation in the surface roughness of the SiC wafer in the annealing process is avoided; in order to avoid a hydrogen etching in the high-temperature annealing activation process from damaging the wafer structure, a high-concentration n-type heavily doped SiC epitaxial layer is firstly epitaxially grown first as a hydrogen etching sacrificial layer; the hydrogen etching rate can be effectively inhibited by introducing a low-flow silicon source in the hydrogen atmosphere, and a silicon-rich and nitrogen-rich surface is formed after the etching of the n-type heavily doped SiC epitaxial layer, so that the mobility of an n-channel of the SiC MOSFET device is further improved.

The beneficial effects are as follows.

**In** comparison with the prior art, the above technical solutions adopted by the material processing method for improving the channel mobility of the silicon carbide metal oxide semiconductor field effect transistor in the present application has the following technical effects.

1. The high-temperature annealing activation is carried out on the SiC wafer after the ion implantation by adopting the same hydrogen atmosphere as that of epitaxial growth by utilizing the SiC epitaxial furnace, which can simplify the process steps of the device, and effectively inhibit the degradation in the surface roughness of the SiC wafer, such that the roughness Rq of the surface area (10 µm×10 µm) of the SiC wafer is greatly reduced from 2.2 nm to 0.295 nm.

2. The high-concentration n-type heavily doped SiC epitaxial layer is epitaxially grown to serve as a sacrificial layer, so that the damage of hydrogen to the SiC wafer structure can be avoided.

3. The hydrogen etching rate can be effectively reduced by introducing a low-flow silicon source in the hydrogen atmosphere, and a silicon-rich and nitrogen-rich interface is formed after the etching of the n-type heavily doped SiC epitaxial layer, so that the mobility of an n-channel of the SiC MOSFET device is further improved.

4. The present application is suitable for the existing commercial SiC epitaxial furnace, the process is compatible with the existing conventional epitaxial process, which can be utilized for mass production of commercial SiC epitaxial wafers.

### BRIEF DESCRIPTION OF THE DRAWINGS

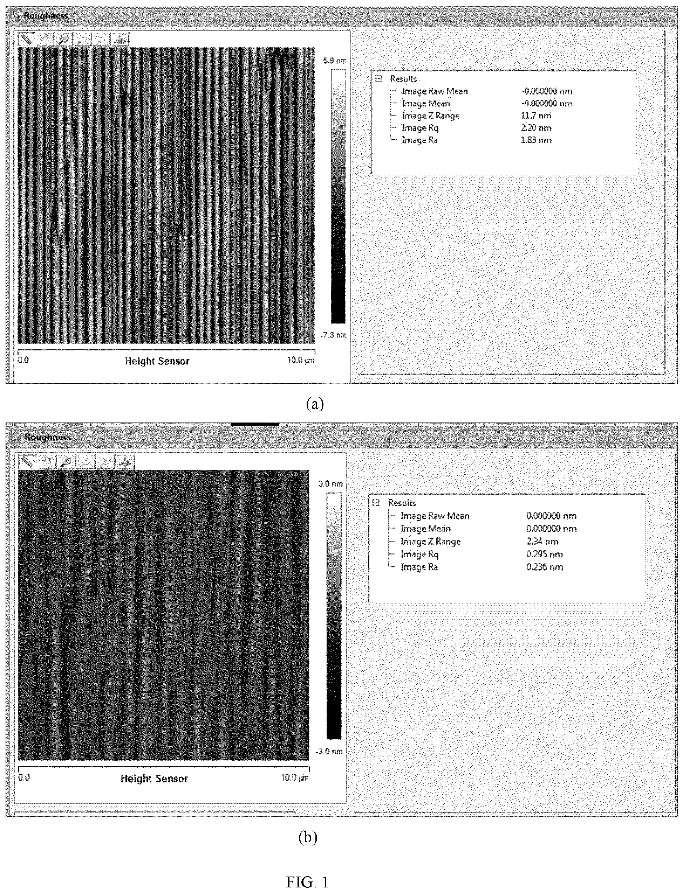

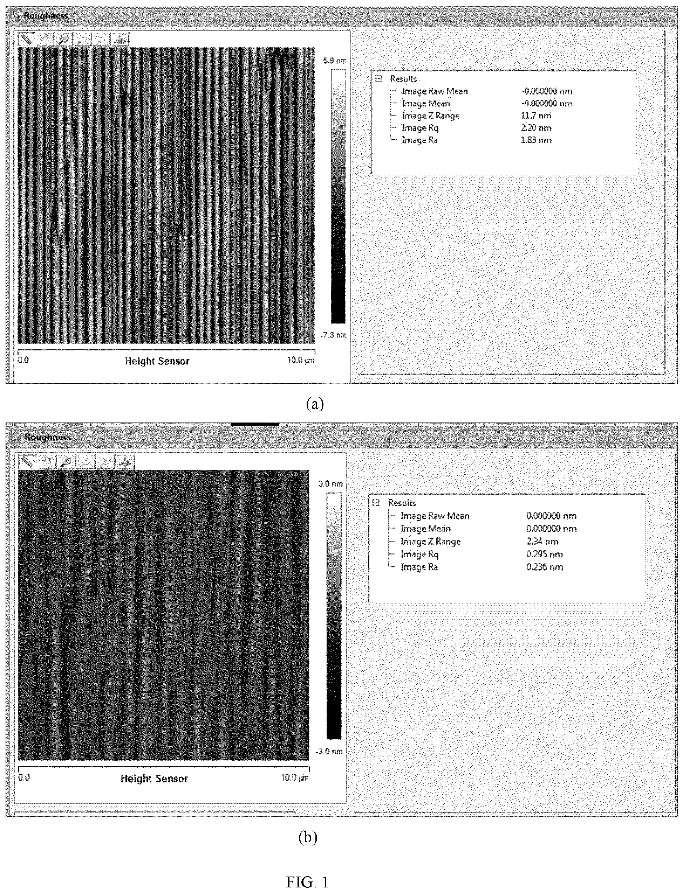

FIG. 1 illustrates a graph comparing the surface roughness of SiC wafers treated by the argon atmosphere high temperature activation method (a) and the method (b) of the present application.

### DETAILED DESCRIPTION OF THE EMBODIMENTS

The following describes the technical solutions of the present application in detail, but the protection scope of the present application includes but is not limited to the embodiments.

### Example 1

The material processing method for improving the channel mobility of the silicon carbide metal oxide semiconductor field effect transistor includes the following specific steps.

In Step 1, the silicon carbide wafer after the n-type implantation and the p-type ion implantation is placed into the reaction chamber, in consideration of the etching of hydrogen to the SiC wafer in the subsequent temperature rising process, the depth of the n-type implantation and p-type implantation is increased by 0.2 microns in comparison with the conventional process.

In Step 2, the reaction chamber is heated to 1500 °C in the hydrogen atmosphere by adopting the chemical vapor deposition CVD equipment, and the temperature is maintained for 0.5 minutes to perform the in-situ pretreatment on the silicon carbide wafer.

In Step 3, the temperature in the reaction chamber is raised to 1580 °C, trichlorosilane, ethylene and nitrogen are introduced, and the n-type heavily doped SiC epitaxial layer is grown on the silicon carbide wafer, the doping concentration of the epitaxial layer is 8E18 cm⁻³. Through the preliminary experimental calibration, the etching rate of hydrogen on the epitaxial layer under the process conditions proposed in Step 4 is 480 nm/h; the proposed processing time for Step 5 is 30 minutes. Therefore, in this step, by adjusting the growth time, the thickness of the n-type heavily doped SiC epitaxial layer is controlled to be 250 nm.

In Step 4, after the growth of the n-type heavily doped SiC epitaxial layer, the temperature in the reaction chamber is raised to 1600 °C; the high-temperature annealing activation treatment is performed on the silicon carbide wafer in the hydrogen atmosphere, and a 30 sccm flow silicon source is introduced during the process of the high-temperature annealing activation treatment to reduce the hydrogen etching rate.

In Step 5, the high-temperature annealing activation time of the hydrogen atmosphere is maintained for 30 minutes, an n-type heavily doped SiC thin layer with the thickness of 10 nm is reserved, and a silicon-rich and nitrogen-rich surface is formed.

In Step 6, a method for forming a silicon dioxide layer by oxidizing a silicon carbide wafer is proposed to be adopted in the subsequent gate oxidation process, trichlorosilane and ethylene are introduced into a reaction chamber, an unintentional doped SiC epitaxial layer with the thickness of 20 nm is grown for improving the quality of silicon dioxide formed by the subsequent oxidation process.

In Step 7, a heater is turned off in the hydrogen atmosphere to naturally cool the reaction chamber to the room temperature.

In Step 8, the reaction chamber is replaced with argon, and the reaction chamber is opened to take out the SiC wafer.

### Example 2

The material processing method for improving the channel mobility of the silicon carbide metal oxide semiconductor field effect transistor includes the following specific steps.

In Step 1, the silicon carbide wafer after the n-type implantation and the p-type ion implantation is placed into the reaction chamber, in consideration of the etching of hydrogen to the SiC wafer in the subsequent temperature rising process, the depth of the n-type implantation and p-type implantation is increased by 0.2 microns in comparison with the conventional process.

In Step 2, the reaction chamber is heated to 1500 °C in the hydrogen atmosphere by adopting the chemical vapor deposition CVD equipment, and the temperature is maintained for 0.5 minutes to perform the in-situ pretreatment on the silicon carbide wafer.

In Step 3, the temperature in the reaction chamber is raised to 1580 °C, trichlorosilane, ethylene and nitrogen are introduced, and the n-type heavily doped SiC epitaxial layer is grown on the silicon carbide wafer, the doping concentration of the epitaxial layer is 8E18 cm⁻³. Through the preliminary experimental calibration, the etching rate of hydrogen on the epitaxial layer under the process conditions proposed in Step 4 is 480 nm/h; the proposed processing time for Step 5 is 30 minutes. Therefore, in this step, by adjusting the growth time, the thickness of the n-type heavily doped SiC epitaxial layer is controlled to be 250 nm.

In Step 4, after the growth of the n-type heavily doped SiC epitaxial layer, the temperature in the reaction chamber is raised to 1600 °C; the high-temperature annealing activation treatment is performed on the silicon carbide wafer in the hydrogen atmosphere, and a 30 sccm flow silicon source is introduced during the process of the high-temperature annealing activation treatment to reduce the hydrogen etching rate.

In Step 5, the high-temperature annealing activation time of the hydrogen atmosphere is maintained for 30 minutes, an n-type heavily doped SiC thin layer with the thickness of 10 nm is reserved, and a silicon-rich and nitrogen-rich surface is formed.

In Step 6, LPCVD deposition equipment is proposed to be adopted in the subsequent gate oxide process to directly grow a silicon dioxide layer; no additional treatment is performed in this step.

In Step 7, a heater is turned off in the hydrogen atmosphere to naturally cool the reaction chamber to the room temperature.

In Step 8, the reaction chamber is replaced with argon, and the reaction chamber is opened to take out the SiC wafer.

The above examples are merely utilized to illustrate the technical solutions of the present application rather than to define the present application. There are many practical production solutions that can be adopted in the production method. All equivalent variations and modifications made according to the claims of the present application are within the scope of the present application.

## Claims

1. A material processing method for improving a channel mobility of a silicon carbide metal oxide semiconductor field effect transistor, **characterized by** performing an in-situ pretreatment on a silicon carbide wafer after an ion implantation in a hydrogen atmosphere by adopting chemical vapor deposition equipment, and growing a high concentration n-type heavily doped SiC epitaxial layer with a concentration of ≥5E17 cm⁻³ on a surface of the silicon carbide wafer after the ion implantation as a sacrificial layer, performing a high-temperature annealing activation treatment on the silicon carbide wafer after the growth of the n-type heavily doped SiC epitaxial layer in the hydrogen atmosphere, after the high temperature annealing activation in hydrogen atmosphere is completed, completely etching and removing the n-type heavily doped SiC epitaxial layer by hydrogen or only leaving a thin layer with a thickness of less than 10 nm, and selecting whether to epitaxially grow an unintentionally doped SiC thin layer according to a difference of whether a process of directly oxidizing the silicon carbide wafer is adopted in a subsequent actually doped gate oxide process or not.

2. The material processing method for improving the channel mobility of the silicon carbide metal oxide semiconductor field effect transistor according to claim 1, **characterized in that** process conditions are specifically:
Step 1, placing the silicon carbide wafer after the n-type implantation and the p-type ion implantation into a reaction chamber;
Step 2, heating, by adopting the chemical vapor deposition CVD equipment, the reaction chamber to a temperature range of 1450 °C to 1550 °C in the hydrogen atmosphere, and keeping the temperature for a duration of 0.5 minutes to 2 minutes to perform the in-situ pretreatment on the silicon carbide wafer;
Step 3, raising the temperature in the reaction chamber to a temperature range of 1550 °C to 1650 °C, introducing a growth source and nitrogen, and growing the n-type heavily doped SiC epitaxial layer on the silicon carbide wafer, wherein a doping concentration of the epitaxial layer is ≥5E17 cm⁻³;
Step 4, raising, after the growth of the n-type heavily doped SiC epitaxial layer, the temperature in the reaction chamber to a temperature range of 1550 °C to 1750 °C; performing the high-temperature annealing activation treatment on the silicon carbide wafer in the hydrogen atmosphere, introducing, during a process of the high-temperature annealing activation treatment, a silicon source with a concentration of ≤0.04%, continuously etching, by hydrogen, the n-type heavily doped SiC epitaxial layer, and controlling time to reserve the n-type heavily doped SiC epitaxial layer with a thickness of 0 nm to 10 nm;
Step 5, selecting, according to the difference of whether the process of directly oxidizing the silicon carbide wafer is adopted in the subsequent actually doped gate oxide process or not, whether to epitaxially grow the unintentionally doped SiC thin layer;
Step 6, turning off a heater in the hydrogen atmosphere to naturally cool the reaction chamber to a room temperature; and
Step 7, replacing the reaction chamber with an argon atmosphere, and opening the reaction chamber to take out the SiC wafer.

3. The material processing method for improving the channel mobility of the silicon carbide metal oxide semiconductor field effect transistor according to claim 1, **characterized in that** in Step 4, the silicon source is silane or trichlorosilane.

4. The material processing method for improving the channel mobility of the silicon carbide metal oxide semiconductor field effect transistor according to claim 1, **characterized by** selecting, according to the difference of whether the process of directly oxidizing the silicon carbide wafer is adopted in the subsequent actually doped gate oxide process or not, whether to epitaxially grow the unintentionally doped SiC thin layer with a thickness of 15 nm to 40 nm in Step 5; directly entering, when low pressure chemical vapor deposition LPCVD equipment is adopted in the subsequent actual gate oxide process to directly grow the silicon dioxide layer, Step 6 with no additional treatment; introducing, when a method for forming silicon dioxide by directly oxidizing a wafer is adopted in the subsequent actual gate oxide process, a growth source into a reaction chamber, and growing an unintentionally doped SiC thin layer with a thickness of 15 nm to 40 nm, namely an unintentionally doped SiC epitaxial layer.

5. The material processing method for improving the channel mobility of the silicon carbide metal oxide semiconductor field effect transistor according to claim 2, **characterized in that** the growth source in Step 3 consists of a silicon source and a carbon source, wherein the silicon source is silane and/or trichlorosilane, and the carbon source is ethylene and/or propane;

6. The material processing method for improving the channel mobility of the silicon carbide metal oxide semiconductor field effect transistor according to claim 2, **characterized in that** the thickness of the n-type heavily doped SiC epitaxial layer grown in Step 3 is not less than a hydrogen etching amount in the high-temperature annealing activation treatment process in the hydrogen atmosphere in Step 4; the hydrogen etching amount is obtainable by multiplying a hydrogen etching rate by the processing time in Step 4; the hydrogen etching rate Er requires an additional experimental calibration: a SiC epitaxial wafer with a known thickness d1 is adopted, a same process condition in Step 4 is adopted to perform a treatment with a duration of t, and a thickness of the SiC epitaxial wafer is measured again to be d2 after the treatment to obtain the hydrogen etching rate Er=(d1-d2)/t.
